Europäisches Patentamt

European Patent Office

Office européen des brevets

(11) Veröffentlichungsnummer: **0 297 375**
**A2**

## EUROPÄISCHE PATENTANMELDUNG

(21) Anmeldenummer: 88109754.7

(22) Anmeldetag: 18.06.88

(51) Int. Cl.4: **H03M 13/12**

(30) Priorität: 02.07.87 DE 3721884

(43) Veröffentlichungstag der Anmeldung:
04.01.89 Patentblatt 89/01

(84) Benannte Vertragsstaaten:
CH FR GB IT LI NL SE

(71) Anmelder: **Meyr, Heinrich, Prof. Dr.**
**Lehrstuhl für Elektrische Regelungstechnik**
**der RWTH Aachen, 5240 Templergraben 55**
**D-5100 Aachen(DE)**

(72) Erfinder: **Fettweis, Gerhard Paul**
**Goethestr. 17**
**D-5100 Aachen(DE)**

(54) **Verfahren zur Ausführung des Viterbi-Algorithmus mit Hilfe parallelverarbeitender Strukturen.**

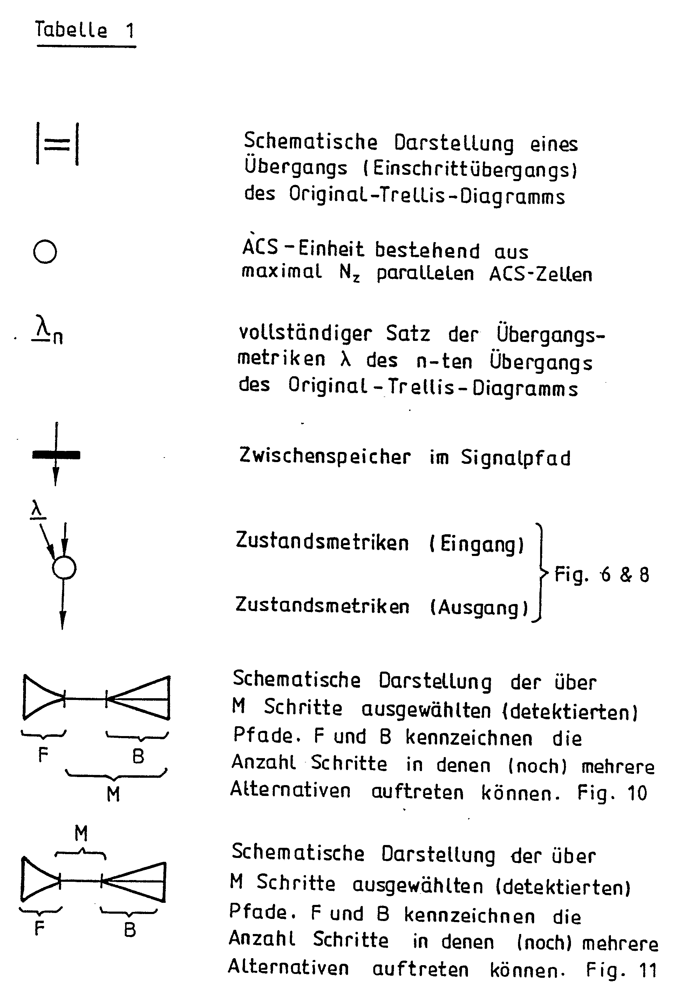

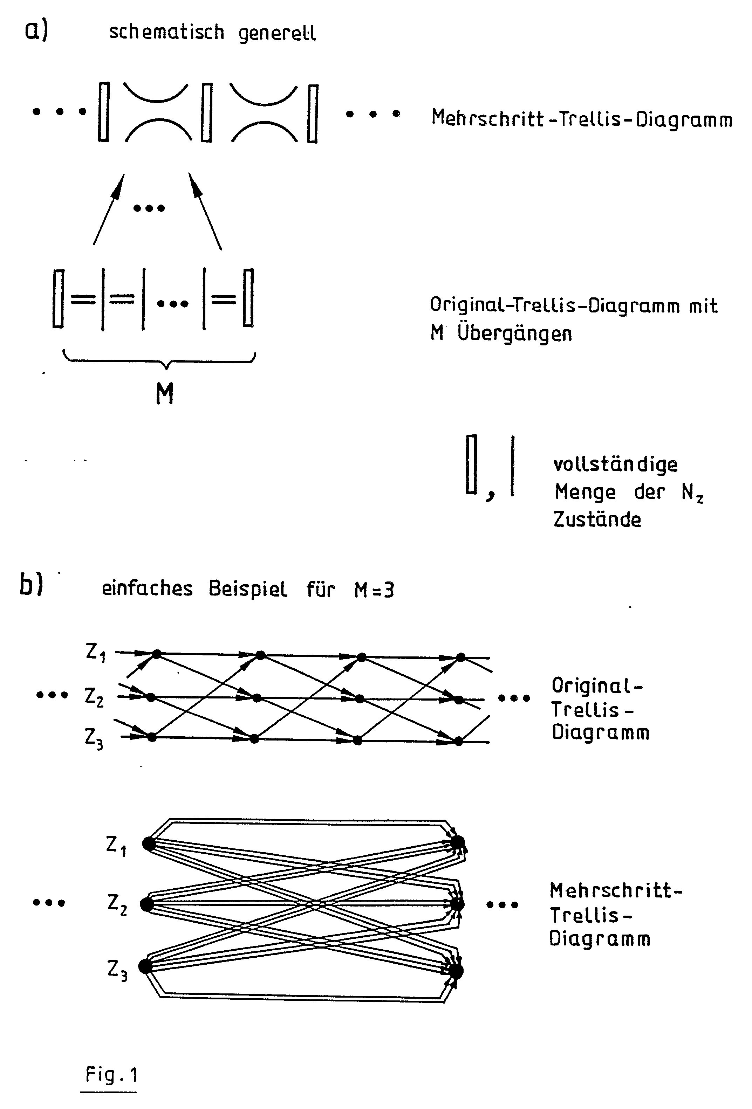

(57) Zur Implementierung des Viterbi-Algorithmus (Viterbi-Dekoder) für sehr hohe Daten-/Dekodierraten wird das zugrunde liegende Trellisdiagramm (Original-Trellisdiagramm) des Markov-Prozesses über eine größere Periode betrachtet. Es werden je M Übergänge des Original-Trellisdiagramms zu einem Mehrschritt-Übergang zusammengefaßt (Mehrschritt-Trellisdiagramm; Fig. 1).

Die dabei exponentiell mit M steigende Anzahl Übergangszweige wird auf ein kleineres Maß vermindert durch Ausnutzen fundamentaler Eigenschaften, des den MehrschrittÜbergängen zugrunde liegenden Original-Trellisdiagramms. Von Mehrschritt-Übergang zu Mehrschritt-Übergang unabhängig werden damit nicht optimale Übergangszweige eliminiert. Das erlaubt den Bau von Viterbi-Dekodern für sehr hohe Datenraten, weil für die Ausführung der Rechenoperationen auf mehreren Rechenwerken mehr Zeit zur Verfügung steht als die maximal erlaubte Zeit für die Ausführung ähnlicher (gleicher) Operationen bei Implementierung des Viterbi-Algorithmus auf der Basis des 1-Schrittübergangs des Original-Trellisdiagramms.

$Z_1$

$Z_2$

$Z_3$

Mehrschritt-
Trellis-
Diagramm

Fig. 1

Xerox Copy Centre

## Verfahren zur Ausführung der Viterbi-Algorithmus mit Hilfe parallelverarbeitender Strukturen

Die Erfindung betrifft ein Verfahren zur Ausführung bzw. Implementierung des Viterbi-Algorithmus (VA) mit Hilfe parallelverarbeitender Strukturen.

Zugrunde liegt ein Markov-Prozess mit einer endlichen Anzahl Zuständen, der vollständig durch ein in seiner Übergangsfolge dargestelltes Zustandsübergangsdiagramm (gleich Trellisdiagramm) beschrieben wird. Ein Übergangszweig des Trellisdiagramms beschreibt die Möglichkeit des Prozesses, vom Ursprungs-Zustand des Zweiges zu seinem Endzustand zu wechseln, in einem gegebenen Zeitintervall. Die Menge aller zeitlich parallel liegenden Übergangszweige wird "Übergang" genannt. Im Deutschen ist es gebräuchlich die Begriffe Zustandsmetrik für "state metric" und Übergangsmetrik für "transition metric" zu verwenden. Der Prozess durchläuft einen Pfad durch das Trellisdiagramm, und ein Beobachter schätzt diesen Pfad mittels des Viterbi-Algorithmus.

Der VA ist ein Algorithmus, um den optimalen Pfad, den der Markov-Prozess durch das Trellisdiagramm durchlaufen hat, zu schätzen. In der Zeitschrift Proceedings of the IEEE, Vol. 61, März 1973, Seiten 268-278 ist der VA beschrieben, der eine Fülle von verschiedenen Anwendungsmöglichkeiten besitzt. Implementierungen des VA, Viterbi-Dekoder (VD) genannt, existieren als Software auf Datenverarbeitungseinheiten (z.B. auch Signalprozessoren), und als eigens dafür aufgebaute Schaltungen, entweder aus handelsüblichen Bauelementen oder auch aus speziellen Integrierten Schaltungen. Immer ist die maximal erzielbare Datenrate durch die verwendeten Bauelemente/Prozessoren (Halbleitertechnologie) begrenzt. Deshalb laufen die bisher erwägten bzw. implementierten Verfahren für hohe Datenraten/Dekodierraten darauf hinaus, einen auf dem Original-Trellisdiagramm basierenden VD zu verwenden, der für jeden Zustand einen getrennten Prozessor besitzt, und diesen dann mit Hilfe der schnellsten Halbleiter-Technologie (ECL) zu bauen (z.B. i.: J. S. Snyder, "High speed Viterbi decoding of high rate codes." 7th International Conference on Digital Satellite Communications, Phoenix, USA, 1983, conf. rec. pp. XII16-XII23; ii.: T. Fujino, Y. Moritani, M. Miyake, K. Murakami, Y. Sakato, and H. Shiino, "A 120 MBit/s 8PSK Modem with soft-decision Viterbi Decoder." International Conference on Digital Satellite Communications 1986, conf. rec. pp. 315-321).

Eine Steigerung der erforderlichen Datenrate über die von der verwendeten Technologie abhängigen Begrenzung hinaus kann prinzipiell nur durch geeignete Parallelverarbeitung erzielt werden. Als wesentlichen Bestandteil enthält der VA jedoch eine nichtlineare Rekursion, die nur der Anzahl Zuständen des zugrunde liegenden Markov-Prozesses entsprechend auf parallelverarbeitende Strukturen abgebildet werden kann. Eine zusätzliche Steigerung der Verarbeitungsgeschwindigkeit eines VD über diese Parallelisierung hinaus erfordert z.B. nicht das Original-Trellisdiagramm für den VA/VD zugrunde zu legen, sondern ein Mehrschritt-Trellisdiagramm (Fig. 1); d.h. die Zustandsübergänge werden dann jeweils über eine größere Periode von M Übergängen betrachtet. Das dabei entstehende neu zugrunde zu legende Trellisdiagramm wird als Mehrschritt-Trellisdiagramm bezeichnet. Damit wird erzielt, daß pro Rekursion eine Anzahl von M Übergängen des Original-Trellisdiagramms dekodiert werden. Allerdings wächst die Anzahl der zu berücksichtigenden Übergangszweige und damit auch der Rechenaufwand des VA, der das Mehrschritt-Trellisdiagramm zugrunde legt, exponentiell mit M. Bisher sind noch keine Verfahren vorgestellt worden, die diesen Aufwand bzw. diese exponentielle Abhängigkeit verringern.

Die Erfindung liegt der Aufgabe zugrunde, Verfahren zur Implementierung und Ausführung, und damit auch Schaltungen und Architekturen anzugeben, mit denen sich beliebige Verarbeitungsgeschwindigkeiten erzielen lassen indem der Viterbi-Algorithmus geeignet parallelisiert wird, wobei der Implementierungsaufwand zur Ausführung des VA nicht in exponentieller sondern in kleiner als exponentieller Abhängigkeit (z.B. linearer) mit der geforderten Daten-/Dekodierrate wächst.

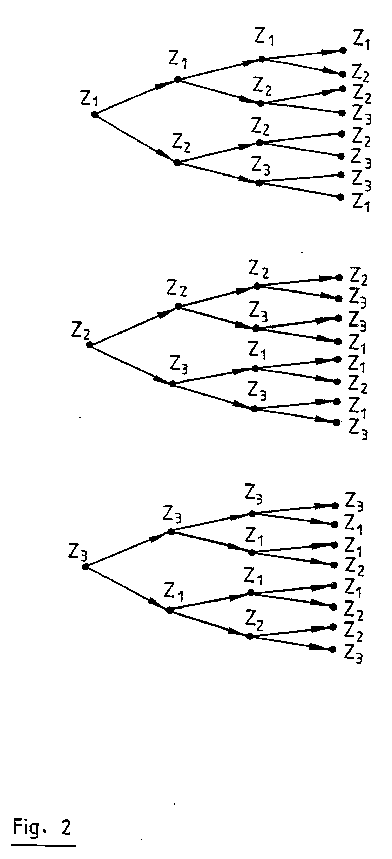

Diese Aufgabe wird erfindungsmäßig dadurch gelöst, daß das Trellisdiagramm des zugrunde liegenden, zu dekodierenden Prozesses über eine größere Periode M > 1 betrachtet wird, indem je M Übergänge des Original-Trellisdiagramms zu einem Mehrschritt-Übergang zusammengefaßt werden (Mehrschritt-Trellisdiagramm, siehe Fig. 1). Fundamentale Eigenschaften des Original-Trellisdiagramms werden ausgenutzt, um die durch das Einführen des Mehrschritt-Trellisdiagramms asymptotisch exponentiell mit M steigende Anzahl von Rechenoperationen (Beispiel Fig. 2) auf ein kleineres Maß/Abhängigkeit zu reduzieren. Dies geschieht in der Art, daß die Ausführung der Rechenoperationen so auf mehrere Rechenwerke verteilt wird, daß bei vorgegebener Daten-/Dekodierrate die Rechenwerke für die Ausführung der Rechenoperationen mehr Zeit zur Verfügung haben als die maximal erlaubte Zeit für die Ausführung ähnlicher (gleicher) Rechenoperationen bei konventioneller Implementierung des Viterbi-Algorithmus.

Vorteilhafte Ausführungen und hierfür mögliche Schaltungen sind in den Unteransprüchen angegeben.

Anhand von Ausführungsbeispielen wird die Erfindung nachstehend noch näher erläutert.

Die mit der Erfindung erzielten Vorteile bestehen darin, daß Lösungsmöglichkeiten zur Implementierung und Ausführung des Viterbi-Algorithmus angegeben werden, womit sich im Prinzip jede gewünschte Daten-/Dekodierrate erzielen läßt. Das Besondere und Neue an dem vorgestellten Verfahren ist, daß dieses mit einem Implementierungsaufwand verbunden ist, der kleiner als exponentiell (im Grenzfall linear) von der gewünschten Rate abhängt.

In den Unteransprüchen sind vorteilhafte Ausgestaltungen angegeben. Anhand von Ausführungsbeispielen wird die Erfindung nachstehend noch näher erläutert werden.

Allgemein sei darauf hingewiesen, daß der Begriff ACS-Einheit das Rechenwerk beschreibt, welches die "add-compare-select"-Operation des Viterbi-Algorithmus für einen gesamten Übergang ausführt. Die maximale Parallelisierung dieser Einheit besteht darin, einen Prozessor/Rechenwerk (gleich ACS-Zelle) für jeden Zustand zu implementieren. Mit dem Begriff ACS-Gesamteinheit ist die Schaltungsanordnung aller im Viterbi-Dekoder implementierten ACS-Einheiten bezeichnet. Weiterhin sei darauf hingewiesen, daß die in den Zeichnungen verwendeten Symbole folgende Bedeutung besitzen.

$N_z$ : die Anzahl der Zustände des zugrunde liegenden Markov-Prozesses und damit des Trellisdiagramms, wobei die Zustände selber mit $Z_1$ , $Z_2$ , bis $Z_{N_z}$ bezeichnet sind.

$\lambda$ : Übergangsmetrik.

Es zeigt in der Zeichnung

Tab. 1 eine beispielsweise Erklärung der in den folgenden Figuren verwendeten Symbole;

Fig. 1 das Prinzip des Einführens eines Mehrschritt-Trellisdiagramms schematisch generell (Fig. 1a), und für ein einfaches Beispiel für $N_z = 3$, $M = 3$ (Fig. 1b),

Fig. 2 für das einfache Beispiel aus Fig. 1, die Baumstruktur der Mehrschritt-Übergangszweige, die vom selben Zustand ausgehen, wenn sie aus den M Übergängen des Original-Trellisdiagramms zusammengesetzt werden,

Fig. 3 für das einfache Beispiel aus Fig. 1 das Prinzip des Zusammensetzens der Übergangszweige des Mehrschritt-Trellisdiagramms aus ihren ursprünglichen Übergangszweigen des Original-Trellisdiagramms,

Fig. 4 für die zusammengesetzten Übergangszweige aus Fig. 3 (des Beispiels aus Fig. 1) ein Beispiel äquivalenter Trellisdiagramme,

Fig. 5 das Blockschaltbild einer Schaltungsanordnung zur Realisierung der ACS-Gesamteinheit durch Multiplexbetrieb von L einzelnen ACS-Einheiten, wobei VD einen Viterbi-Dekoder bezeichnet,

Fig. 6 das Blockschaltbild einer Schaltungsanordnung zur Realisierung der ACS-Gesamteinheit in systolischer Struktur, beispielhaft gezeigt für $N_z = 3$ und $M = 9$ (Multiplexbetrieb von $L = 24$ ACS-Einheiten, plus einer ACS-Einheit für das Mehrschritt-Trellisdiagramm), wobei das Nachvollziehen des Arbeitstakts der Schaltungsanordnung durch Inkrementieren von $l$ durchzuführen ist,

Fig. 7 das Blockschaltbild einer Schaltungsanordnung zur Realisierung der ACS-Gesamteinheit bei gegebenem $M > F$ durch doppelten Multiplexbetrieb von insgesamt L einzelnen ACS-Einheiten, plus einer ACS-Einheit für das Mehrschritt-Trellisdiagramm,

Fig. 8 das Blockschaltbild einer Schaltungsanordnung zur Realisierung der ACS-Gesamteinheit in systolischer Struktur bei gegebenem $M > F$ (Multiplexbetrieb von $L = (F-1)N_z + M-1$ (ACS-Einheiten, plus einer ACS-Einheit für das Mehrschritt-Trellisdiagramm), wobei das Nachvollziehen des Arbeitstakts der Schaltungsanordnung durch Inkrementieren von $l$ durchzuführen ist,

Fig. 9 das Prinzip der Anordnung von Trellisdiagrammen, die sich jeweils um entsprechend F Übergängen des Original-Trellisdiagramm überlappen, wobei in der Figur die gleichen Übergänge (durch das Überlappen) senkrecht übereinander angeordnet sind,

Fig. 10 die Anordnung von dekodierten Pfaden entsprechend Fig. 8 , jedoch für $M > B$, mit dem Prinzip der rückkopplungsfreien Dekodierung, wobei in der Figur die gleichen Übergänge (durch das Überlappen) senkrecht übereinander angeordnet sind,

Fig. 11 das Prinzip der Anordnung der dekodierten Pfade, die sich jeweils um entsprechend F + B Übergängen des Original-Trellisdiagramms überlappen, wobei in der Figur die gleichen Übergänge (durch das Überlappen) senkrecht übereinander angeordnet sind,

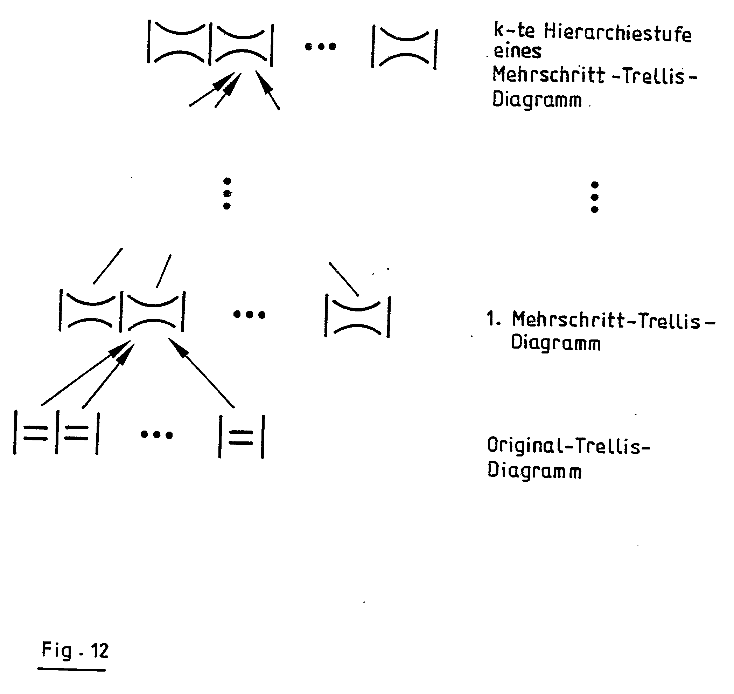

Fig. 12 das Prinzip, schematisch generell, des Einführens mehrerer Hierarchiestufen von Trellisdiagrammen.

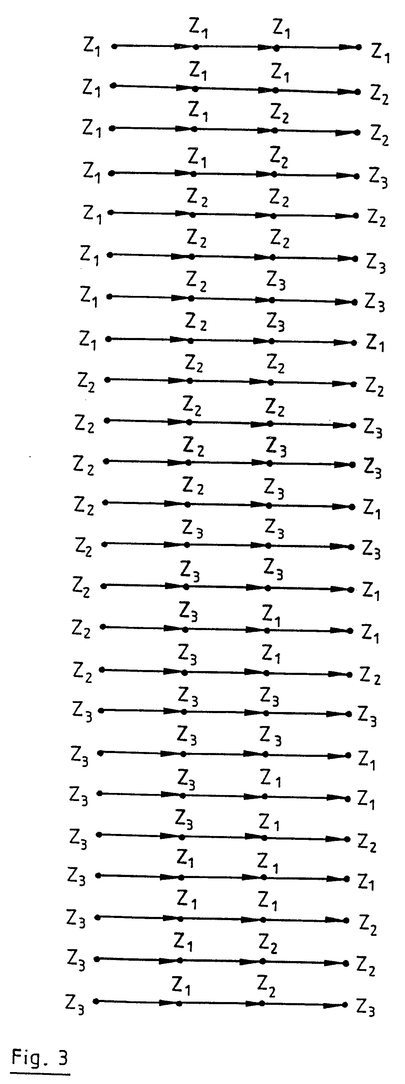

In Fig. 1 ist das grundsätzliche Verfahren des Einführens eines Mehrschritt-Trellisdiagramms beispielhaft für $M = 3$ dargestellt. Das exponentielle Wachstum der Anzahl Übergangszweige in Abhängigkeit von M verdeutlicht (für das einfache Beispiel aus Fig. 1 mit $3 \times 2^M$) die in Fig. 2 dargestellte Baumstruktur. Für das dargestellte einfache Beispiel verdoppelt sich damit die Anzahl Übergangszweige bei jedem Vergrößern von M um eins. Durch das Zurückführen der Übergangszweige eines Mehrschritt-Übergangs auf seine Übergangszweige des Original-Trellisdiagramms (für das einfache Beispiel, dargestellt in Fig. 3), ergibt sich eine Fülle von Möglichkeiten, diese Mehrschritt-Übergangszweige zu Trellisdiagrammen zusammenzufassen.

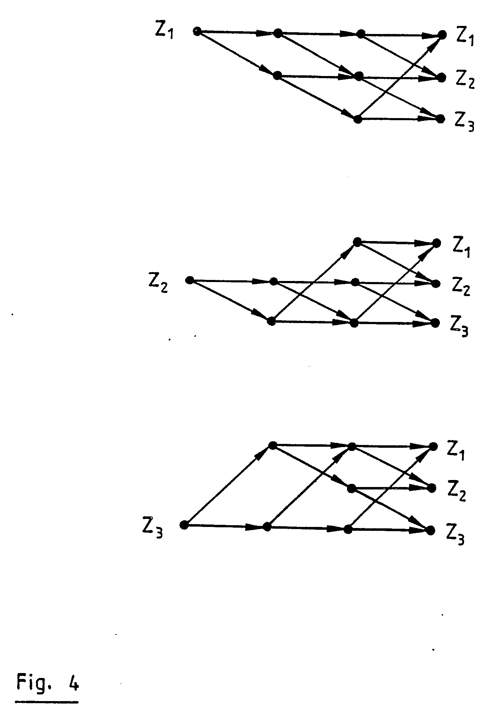

Ein Beispiel für das Zusammenfassen dieser Übergangszweige zu Trellisdiagrammen ist für das einfache Beispiel aus Fig. 1 in Fig. 4 abgebildet.

Dieses Vorgehen erlaubt es nun, den Viterbi-Algorithmus zu verwenden, basierend jeweils auf den somit erzeugten, in ihrer Anzahl Übergänge beschränkten Trellisdiagrammen. Damit werden nicht optimale, parallele Übergangszweige des Mehrschritt-Trellisdiagramms eliminiert (parallel heißt in diesem Fall, daß die Übergangszweige zum gleichen Zeitpunkt vom gleichen Anfangszustand ausgehen, und zum gleichen Zeitpunkt beim gleichen Endzustand enden).

Besonders einfach und anschaulich läßt sich dieses Verfahren erläutern, wenn die Trellisdiagramme so erzeugt werden, daß jeweils alle Übergangszweige des Mehrschritt-Trellisdiagramms, die vom selben Zustand ausgehen, zu genau einem Trellisdiagramm zusammengefaßt werden (wie es für das oben zitierte einfache Beispiel in Fig. 4 gezeigt wird). Damit wird durch das Verwenden des Viterbi-Algorithmus, basierend auf diesen Trellisdiagrammen, genau der einzige optimale Übergangszweig ermittelt, aus jeder Menge paralleler Zweige des Mehrschritt-Trellisdiagramms. Dadurch kann das Mehrschritt-Trellisdiagramm besonders einfach dekodiert werden, z.B. mit Hilfe des Viterbi-Algorithmus, der dann keine parallelen Übergangszweige zu berücksichtigen braucht.

Der zusätzliche Rechenaufwand der mit diesem Verfahren verbunden ist, gegenüber einer auf den Einschritt-Übergang (durchgehendes Original-Trellisdiagramm) zurückgreifenden (konventionellen) Implementierung ist verbunden mit dem Faktor $N_z$, der Anzahl der Zustände. Das ist die minimale Anzahl ($N_z$) Trellisdiagramme die benötigt werden, um einen Mehrschritt-Übergang fehlerfrei dekodieren zu können. Das hier beschriebene Verfahren führt, bei einer beliebigen Steigerung der Verarbeitungsgeschwindigkeit eines darauf basierenden Viterbi-Dekoders, zu einer linearen Abhängigkeit des Implementierungsaufwands von der gewünschten Datenrate. Der Grund dafür ergibt sich daraus, daß alle Viterbi-Algorithmen, die über Trellisdiagramme mit einer beschränkten Anzahl Übergängen ausgeführt werden, unabhängig voneinander auf getrennten VDs gerechnet werden können. Dies muß einzig und allein so geschehen, daß der VD des Mehrschritt-Trellisdiagramms die Ergebnisse der anderen VDs zu der von ihm geforderten Zeit erhält.

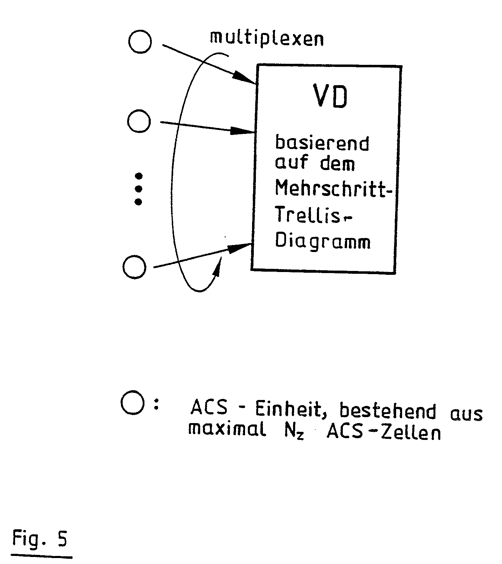

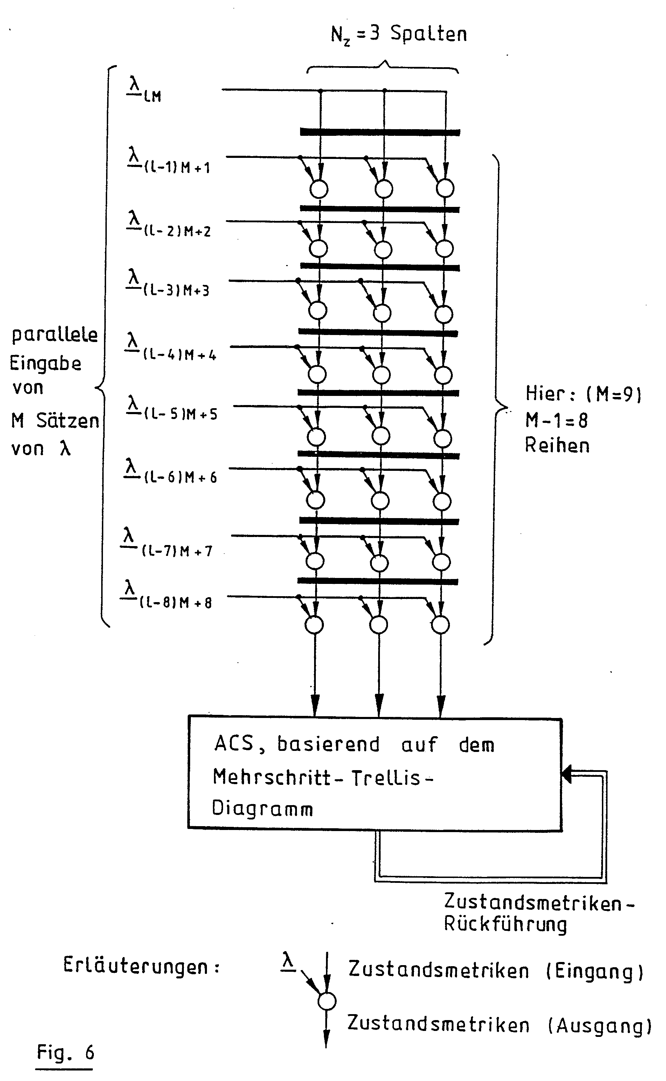

In Fig. 5 ist beispielhaft eine Schaltungsanordnung zur Realisierung der ACS-Gesamteinheit dieses Verfahrens in Multiplex-Struktur dargestellt (ACS: add-compare-select, die arithmetische Rückkopplungseinheit, die die Verarbeitungsrate des Viterbi-Dekoders beschränkt); und in Fig. 6 eine entsprechende systolische Struktur.

Durch den dargestellten Multiplexbetrieb mehrerer ACS-Einheiten läßt sich eine relativ einfache Implementierung gewinnen.

Die in Fig. 5 dargestellte Schaltungsanordnung stellt das Prinzip der Implementierung von insgesamt L ACS-Einheiten dar. Sie führen alle die gesamten zur Ausführung des Viterbi-Algorithmus, basierend auf den in ihrer Anzahl Übergängen begrenzten Trellisdiagrammen, notwendigen ACS-Operationen aus. Die Ergebnisse dieser ACS-Einheiten werden dem auf dem Mehrschritt-Trellisdiagramm basierenden VD zugeführt, der die ausgewählten Pfade samt ihrer Metriken erhält. Das Multiplexen der Eingangswerte zu den ACS-Einheiten und das Multiplexen der durch sie erhaltenen Ergebnisse zum VD geschieht in der Form, daß der VD die Ergebnisse in der von ihm benötigten Reihenfolge entsprechend der Mehrschritt-Übergänge erhält.

In der in Fig. 6 dargestellte systolische Schaltungsanordnung ist eine andere Form des Multiplexens dargestellt. Jede dort dargestellte ACS-Einheit aus dem Feld von 3x8 ACS-Einheiten führt nur eine ACS-Operation für ein in seiner Anzahl Übergänge beschränktes Trellisdiagramm aus. Die Ausführung des Viterbi-Algorithmus schreitet demnach von oben nach unten durch die Reihen fort. In Fig. 6 entspricht das dem Inkrementieren von $t$.

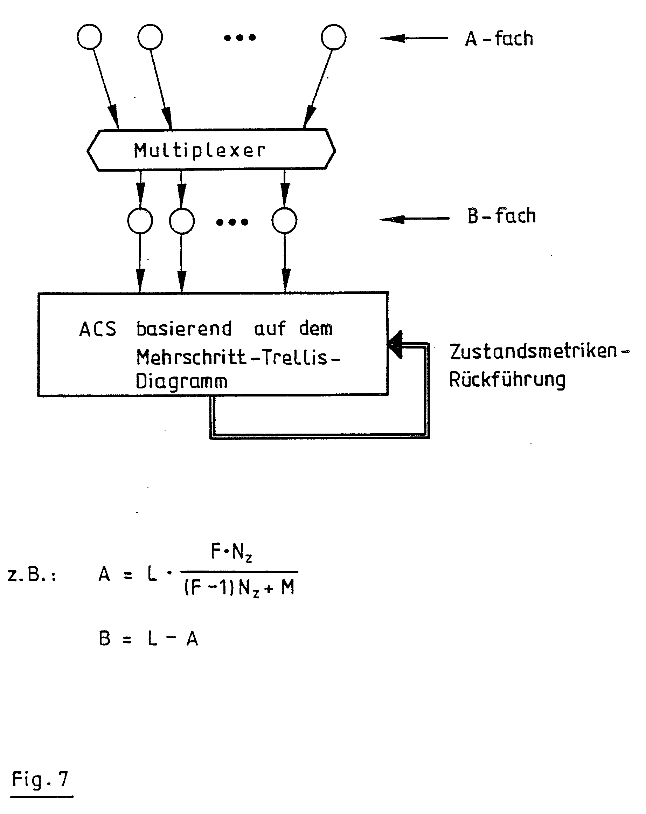

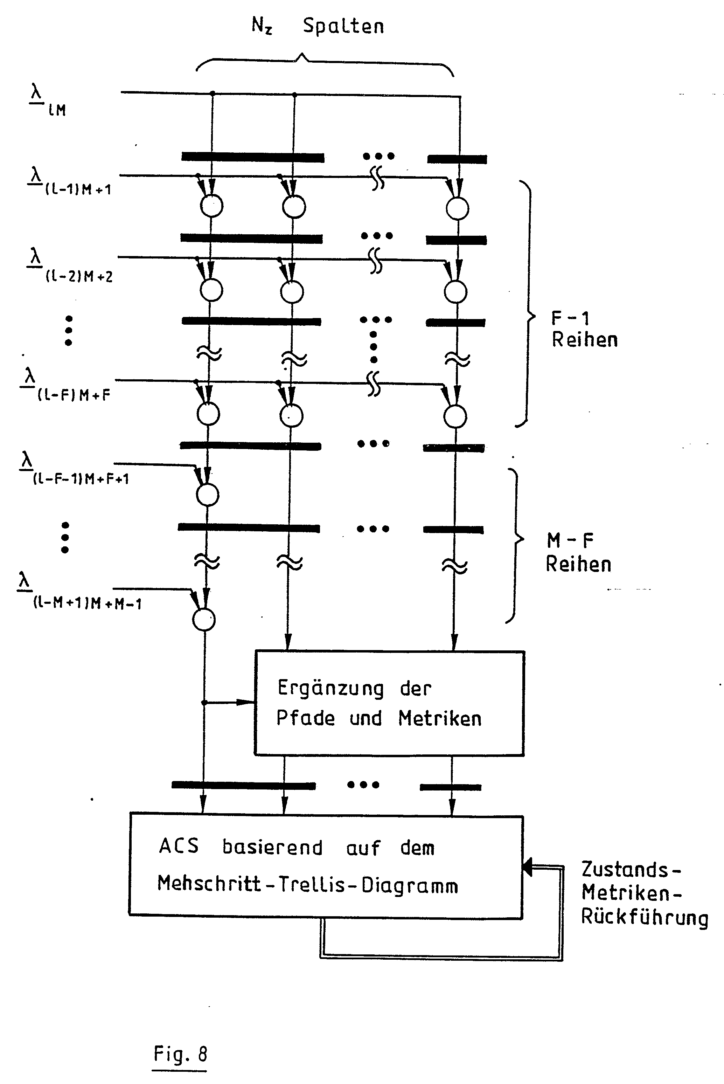

In dem oben erläuterten Verfahren existieren für jeden Mehrschritt-Übergang eine Anzahl N von Trellisdiagrammen, die zusammen einen Mehrschritt-Übergang vollständig beschreiben (N kann von Mehrschritt-Übergang zu Übergang variabel sein). Zur Eliminierung nicht optimaler Pfade innerhalb dieser Trellisdiagramme wird der Viterbi-Algorithmus verwendet. Abhängig vom zugrunde liegenden Markov-Prozeß wird nun mit großer Wahrscheinlichkeit der Viterbi-Algorithmus dazu führen, daß ab einer Anzahl F von Übergängen die gleichen Pfade erhalten (berechnet) werden, unabhängig davon welches der N Trellisdiagramme verwendet wird. Daher ist es sinnvoll den Viterbi-Algorithmus nur über einen der N Trellisdiagramme vollständig auszuführen, und den VA nur über F Übergänge der anderen N-1 Trellisdiagramme auszuführen. Die Pfade und Metriken der nach F Übergängen abgebrochenen Viterbi-Algorithmen müssen dann entsprechend den Pfaden und Metriken des einen vollständig durchgeführten Viterbi-Algorithmus ergänzt werden. Dadurch verringert sich die Anzahl der durchzuführenden Rechenoperationen unter Umständen erheblich. Eine Implementierung der ACS-Gesamteinheit dieses Verfahrens läßt sich vorteilhaft in der in Fig. 7 dargestellten Multiplex-Struktur oder in der in Fig. 8 dargestellten systolischen Struktur ausführen (dieselben Erläuterungen, wie sie oben zu Fig. 5 und Fig. 6 stehen, gelten zum Verständnis der hier zitierten Figuren entsprechend).

Dieses Variante des vorher beschriebenen Verfahrens erlaubt eine Einsparung an Rechenaufwand, je nach Voraussetzungen, um z.B. $(N_z - 1)(M - F)/M$, verbunden mit derselben Implementierungs-Einsparung.

Ein etwas anderes Verfahren soll im Folgenden erläutert werden. Dem Mehrschritt-Trellisdiagramm wird für jeden Übergang wieder das entsprechende (vollständige) Original-Trellisdiagramm zugrunde gelegt. Dieses begrenzte Original-Trellisdiagramm wird um eine Anzahl F Übergänge so erweitert, daß ein darauf basierender Viterbi-Algorithmus diese F Übergänge zu Beginn verwendet, um mit der Ausführung des Algorithmus über die zusätzlichen F Übergänge, seine Akquisition abzuschließen. Die Akquisition des ausgeführten Viterbi-Algorithmus bedeutet, daß nach Ausführung des VA über die zusätzlichen F Übergänge, mit hoher Wahrscheinlichkeit gesichert ist, daß bei weiterer Ausführung des VA über die folgenden Übergänge der optimale Pfad unter den erhaltenen Pfaden ist, wie er durch einen durchgehend über das ganze Trellisdiagramm ausgeführten VA ermittelt würde. Dabei soll hier angemerkt sein, daß die Größe F selbstverständlich zum einen abhängt von der Wahl des hinzugefügten Trellisdiagramms welches aus den zusätzlichen F Übergängen gebildet werden muß, und zum anderen abhängt von der Anfangsbelegung der Zustandsmetriken.

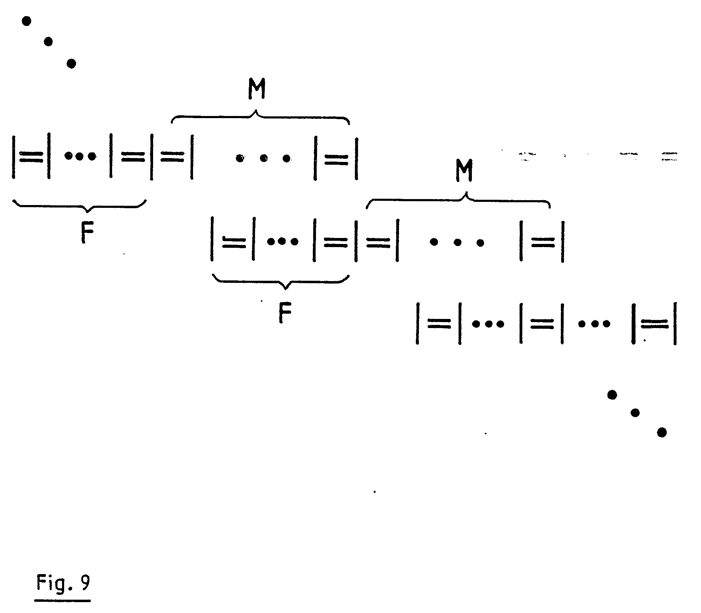

Bei diesem Verfahren überlappen sich die benachbarten, beschränkten Trellisdiagramme jeweils um entsprechend F Übergänge (Fig. 9). Damit werden die darauf basierenden Viterbi-Algorithmen über entsprechend M + F Übergänge ausgeführt, wodurch ihre Akquisition bereits abgeschlossen ist, bevor sie die M Übergänge dekodieren. Damit ist mit großer Wahrscheinlichkeit sichergestellt, daß der optimale Pfad dekodiert wird, und es entfällt ein übergeordneter, auf dem Mehrschritt-Trellisdiagramm basierender Viterbi-Algorithmus (und der dafür notwendige VD) fast vollständig. Der notwendige Dekoder besteht nur noch aus einem dem des Viterbi-Algorithmus entsprechenden Pfad-Speiichers ("survivor memory").

Der Vorteil dieses Verfahrens gegenüber den oben beschriebenen ist, daß hier der zusätzliche Rechenaufwand gegenüber einer Implementierung, die auf den Einschritt-Übergang (durchgehendes Original-Trellisdiagramm) zurückgreift (konventionellen), verbunden ist mit dem Faktor (M + F)/M, der unabhängig von $N_z$ ist und für große M vernachlässigbar gering ist.

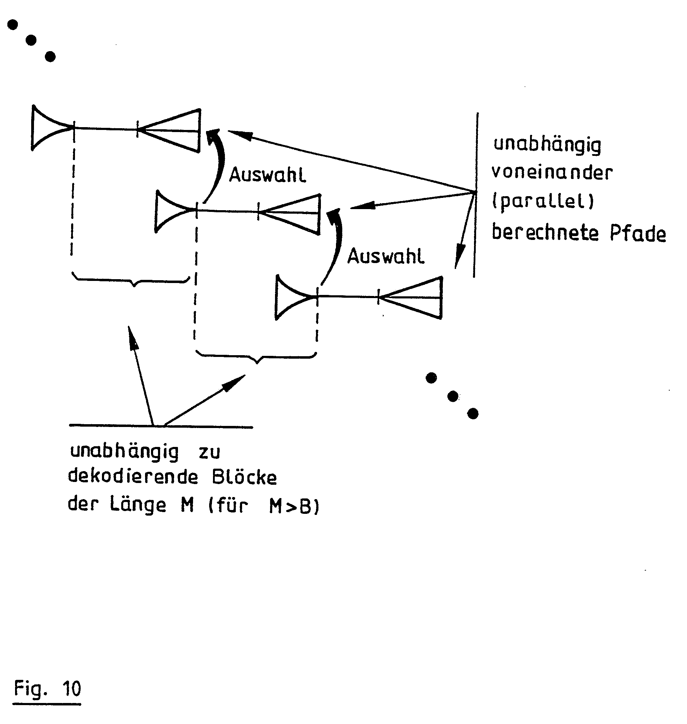

Noch deutlicher wird das letztdiskutierte Verfahren für M > B, d.h. daß die benötigte Survivor-Länge B kleiner ist als die Anzahl Übergänge pro Mehrschritt-Übergang. Dann kann gemäß Fig. 10 abhängig nur vom Ergebnis des ausgeführten Viterbi-Algorithmus (bzw. des zugehörenden VD), der auf dem benachbarten Trellisdiagram basiert, aber rückkopplungsfrei dekodiert werden.

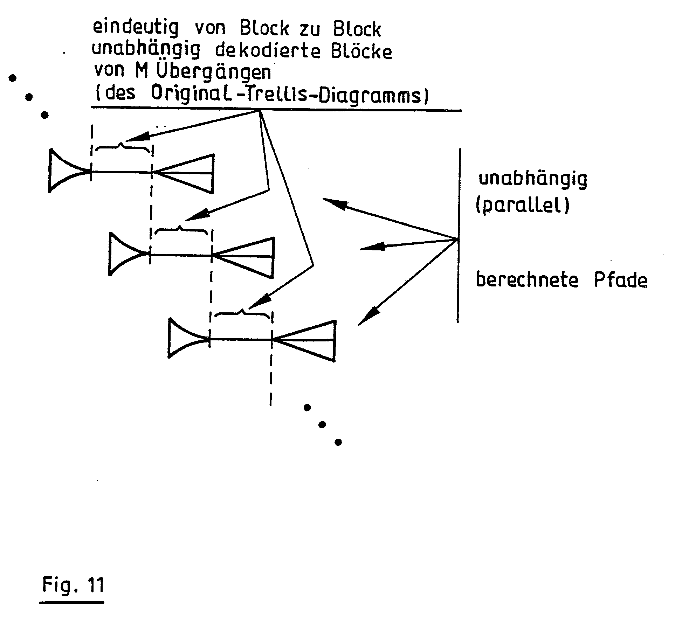

Aus dem oben beschriebenen Verfahren läßt sich für M > B eine weitere Variante dieses Verfahrens heleiten. Wie schon aus Fig. 10 abgelesen werden kann sind bei dem oben beschriebenen Verfahren für M > B bereits pro ausgeführten Viterbi-Algorithmus M - B Übergänge eindeutig dekodiert. Fügt man demnach an jedes in seiner Anzahl Übergängen begrenztes Trellisdiagramm eine Anzahl von B Übergängen so an, daß der ausgeführte Viterbi-Algorithmus diese zuletzt verwendet, so existieren pro ausgeführten Viterbi-Algorithmus (mit hoher Wahrscheinlichkeit) M eindeutig dekodierte Übergänge (siehe Fig. 11). Es sind damit die M Übergänge, die zusammen einen Mehrschritt-Übergang bilden, eindeutig dekodiert. Die zugrunde zu legenden Trellisdiagramme überlappen sich damit nicht nur um entsprechend F, sondern um F + B Übergänge (des Original-Trellisdiagramms). Der Vorteil dieses Verfahrens gegenüber dem vorher beschriebenen Verfahren des Einführens von nur F zusätzlichen Übergängen besteht darin, daß bei diesem Verfahren die Implementierung des übergeordneten Pfadspeichers vollständig entfällt. Das wird erkauft durch eine größere Zahl an notwendigen Rechenoperationen ca. um den Faktor (M + F + B)/(M + F), der für sehr große M vernachlässigbar klein wird. Diese ist insbesondere deshalb interessant, weil M unabhängig von der gewünschten Daten-/Dekodierrate gewählt werden kann.

Es sei noch darauf hingewiesen, daß jeder auf ein beschränktes Trellisdiagramm ausgeführte Viterbi-Algorithmus selbstverständlicherweise nicht nur in der vom Markov-Prozess vorgeschriebenen Folge die Übergänge verwenden kann, sondern auch in der inversen Reihenfolge. Das entspricht einer (möglicherweise nur abschnittsweisen) Invertierung des Markov-Prozesses.

## Ansprüche

1. Verfahren zur Implementierung bzw. Ausführung des Viterbi-Algorithmus mit Hilfe parallelverarbeitender Strukturen, für beliebige Trellisdiagramme (Zustandsübergangsidiagramme), dadurch gekennzeichnet, daß
- das Trellisdiagramm (Original-Trellisdiagramm) des zugrunde liegenden, zu dekodierenden Prozesses über eine größere Periode M > 1 betrachtet wird, indem je M Schritte/Übergänge ("transitions") des Original-Trellisdiagramms zu einem Mehrschritt-Übergang zusammengefaßt werden (Mehrschritt-Trellisdiagramm, siehe Fig. 1), und daß
- fundamentale Eigenschaften des Original-Trellisdiagramms ausgenutzt werden, um die durch das Einführen des Mehrschritt-Trellisdiagramms asymptotisch exponentiell mit M steigende Anzahl von Rechenoperationen (Beispiel Fig. 2) auf ein kleineres Maß/Abhängigkeit zu reduzieren, wobei dieses so geschieht, daß
- die Ausführung der Rechenoperationen so auf mehrere Rechenwerke verteilt wird, daß bei vorgegebener Daten-Dekodierrate die Rechenwerke für die Ausführung der Rechenoperationen mehr Zeit zur Verfügung haben als die maximal erlaubte Zeit für die Ausführung ähnlicher (gleicher) Rechenoperationen bei Implementierung des Viterbi-Algorithmus auf Basis des 1-Schritt-Übergangs (Original-Trellisdiagramm).

2. Verfahren nach Anspruch 1, dadurch gekennzeichnet, daß die Anzahl (M), der zum Mehrschritt-Übergang zusammengefaßten Übergänge des Original-Trellisdiagramms, im Mehrschritt-Trellisdiagramm variabel ist.

3. Verfahren nach Anspruch 1 oder 2, dadurch gekennzeichnet, daß
- die Übergangszweige des Mehrschritt-Trellisdiagramms wieder aus ihren ursprünglichen M Übergangszweigen des Original-Trellisdiagramms zusammendesetzt werden (Beispiel siehe Fig. 3) und dann so zu Trellisdiagrammen zusammengefaßt werden, daß
- der Viterbi-Algorithmus zur Eliminierung nicht optimaler Übergangszweige verwendet wird (der Viterbi-Algorithmus wird dann nur jeweils über eine begrenzte Anzahl von maximal $M_o = M$, allgemein $M_o \leq M$ Rekursionen ausgeführt; Beispiel siehe Fig. 4),
- zum Dekodieren des Mehrschritt-Trellisdiagramms nur die geringere Zahl der dabei ausgewählten Übergangszweige verwendet wird.

4. Verfahren nach einem der vorhergehenden Ansprüche, dadurch gekennzeichnet, daß das Zusammenfassen der Mehrschritt-Übergangszweige zu Trellisdiagrammen so vollzogen wird, daß alle Übergangszweige ("transition branches") des Mehschritt-Trellisdiagramms, die vom selben Zustand ausgehen, zu genau Trellisdiagramm zusammengefaßt werden (Beispiel Fig. 4).

5. Verfahren nach Anspruch 4, dadurch gekennzeichnet, daß alle Trellisdiagramme, die zusammen einen Übergang (bzw. Mehrschritt) des Mehrschritt-Trellisdiagramms beschreiben, so gebildet werden, daß sie die gleiche Anzahl von $M_o$ Übergängen besitzen.

6. Verfahren nach einem der vorhergehenden Ansprüche 3 bis 5, dadurch gekennzeichnet, daß
- für große M , und ausgehend von allen Trellisdiagrammen, die nach den oben zitierten Ansprüchen jeweils zusammen einen Mehrschritt-Übergang beschreiben, der Viterbi-Algorithmus nur für ein Trellisdiagramm über alle Übergänge des Trellisdiagramms ausgeführt wird, während für alle anderen Trellisdiagramme der Viterbi-Algorithmus nur über F Schritte/Übergänge ausgeführt wird, und,
- die dabei ausgewählten Pfade und Metriken gemäß den Pfaden und Metriken des vollständig ausgeführten Viterbi-Algorithmus ergänzt (vervollständigt) werden.

7. Verfahren nach Anspruch 6, dadurch gekennzeichnet, daß die Viterbi-Algorithmen, die nicht vollständig ausgeführt werden, nicht alle einheitlich nach F Übergängen abgebrochen werden, sondern nach einer beliebig unterschiedlichen Anzahl von Übergängen.

8. Verfahren zur Implementierung bzw. Ausführung des Viterbi-Algorithmus mit Hilfe parallelverarbeitender Strukturen nach Anspruch 1 oder 2, dadurch gekennzeichnet, daß
- jedem Übergang des Mehrschritt-Trellisdiagramms wieder sein über M Schritte/Übergänge beschränktes, bezüglich der Übergangszweige vollständiges Original-Trellisdiagramm zugrunde gelegt wird,
- dieses Trellisdiagramm um zusätzlich F Übergänge so erweitert wird, daß
- bei Verwendung eines Viterbi-Algorithmus zur Dekodierung dieses Trellisdiagramms, diese F zusätzlichen Übergänge zu Beginn verwendet werden, um mit großer Wahrscheinlichkeit sicherzustellen, daß bei der weiteren Ausführung des Viterbi-Algorithmus auf die M Übergänge (entsprechend dem Original-Trellisdiagramm) des Mehrschritt-Übergangs, der optimale Pfad als einer der Pfade erhalten wird (wie er von einen durchgehend ausgeführten Viterbi-Algorithmus gefunden würde),
- die von Mehrschritt-Übergang zu Mehrschrittübergang unabhängige Ausführung dieses Viterbi-Algorithmus auf mehreren Rechenwerken (unabhängig voneinander) durchgeführt wird,
- zur Dekodierung des Mehrschritt-Trellisdiagramms die so erhaltenen, über eine begrenzte Zahl von Übergängen verlaufenden Pfade mit Hilfe eines übergeordneten Rechenwerks verarbeitet werden, um den optimalen Pfad zu dekodieren (dem "survivor memory" des Viterbi-Algorithmus entsprechend, siehe Fig. 9).

9. Verfahren nach Anspruch 8, dadurch gekennzeichnet, daß ein oder mehrere beliebige Trellisdiagramme, welche aus dem Original-Trellisdiagramm durch Zusammenfassen von Übergängen (und/oder Übergangszweigen) hergeleitet werden können, statt dem (bzw. in beliebiger Reihenfolge abwechselnd mit dem) Original-Trellisdiagramm verwendet werden.

10. Verfahren nach Ansprüchen 8 oder 9, dadurch gekennzeichnet, daß M größer ist als die benötigte Survivor-Länge B (M > B), und daß keine Rückkopplung über mehrere Mehrschritt-Übergänge hinweg für die Dekodierung des Mehrschritt-Trellisdiagramms besteht (Fig. 10).

11. Verfahren nach Anspruch 10, dadurch gekennzeichnet, daß
- jedem Trellisdiagramm, das über eine beschränkte Anzahl von F + M Übergängen verläuft, weitere B Übergänge so hinzugefügt werden (wobei B der benötigten Survivor-Länge entspricht), daß diese vom ausgeführten Viterbi-Algorithmus als letzte Übergänge verarbeitet werden,
- der eindeutige Pfad des dekodierten Übergangs des Mehrschritt-Trellisidagramms (gleich M Übergängen des Original-Trellisdiagramms) unabhängig von allen anderen Übergängen des Mehrschritt-Trellisdiagramms ausgegeben wird,
- kein übergeordnetes Rechenwerk benötigt wird (Fig. 11).

12. Verfahren nach einem der vorhergehenden Ansprüche, dadurch gekennzeichnet, daß eine beliebige Menge der in ihrer Anzahl Übergängen begrenzten Trellisdiagramme, statt in ihrer vorgegebenen Richtung, gleich Reihenfolge der Übergänge, in der inversen Richtung als Grundlage für den darauf basierenden Viterbi-Algorithmus verwendet werden (inverser Markov-Prozess).

13. Verfahren nach den vorhergehenden Ansprüchen, dadurch gekennzeichnet, daß eine beliebige Kombination der in den Ansprüchen spezifizierten Verfahren seine Anwendung findet.

14. Verfahren nach einem der vorhergehenden Ansprüche, dadurch gekennzeichnet, daß das prinzipielle Verfahren des Einfügens einer zusätzlichen Hierarchiestufe mittels des Mehrschritt-Trellisdiagramms, durch das Einfügen beliebig vieler weiterer Hierarchiestufen (z.B. ein Mehr-Mehrschritt-Trellisdiagramm) verallgemeinert wird (Fig. 12).

15. Schaltungsanordnung zur Durchführung des Verfahrens nach einem der vorhergehenden Ansprüche 3 bis 14, dadurch gekennzeichnet, daß zur Ausführung der Viterbi-Algorithmen, die über eine begrenzte Zahl von Übergängen ausgeführt werden, eine Zahl von L Rechenwerken im Zeitmultiplex betrieben werden (schematische Beispiele Fig. 5, Fig. 7).

16. Schaltungsanordnung nach Anspruch 15, dadurch gekennzeichnet, daß die L Rechenwerke in einer systolischen Struktur aufgebaut werden (schematische Beispiele Fig. 6, Fig. 8).

Tabelle 1

|=|    Schematische Darstellung eines Übergangs (Einschrittübergangs) des Original-Trellis-Diagramms

○    ACS-Einheit bestehend aus maximal $N_z$ parallelen ACS-Zellen

$\underline{\lambda}_n$    vollständiger Satz der Übergangs-metriken λ des n-ten Übergangs des Original-Trellis-Diagramms

Zwischenspeicher im Signalpfad

$\lambda$    Zustandsmetriken (Eingang)

Zustandsmetriken (Ausgang)    } Fig. 6 & 8

Schematische Darstellung der über M Schritte ausgewählten (detektierten) Pfade. F und B kennzeichnen die Anzahl Schritte in denen (noch) mehrere Alternativen auftreten können. Fig. 10

Schematische Darstellung der über M Schritte ausgewählten (detektierten) Pfade. F und B kennzeichnen die Anzahl Schritte in denen (noch) mehrere Alternativen auftreten können. Fig. 11

**a)** schematisch generell

Mehrschritt-Trellis-Diagramm

Original-Trellis-Diagramm mit M Übergängen

M

$\Big\|, \Big|$ vollständige Menge der $N_z$ Zustände

**b)** einfaches Beispiel für M=3

$Z_1$
$Z_2$
$Z_3$

Original-Trellis-Diagramm

$Z_1$
$Z_2$
$Z_3$

Mehrschritt-Trellis-Diagramm

Fig.1

Fig. 2

Fig. 3

Fig. 4

VD

basierend
auf dem
Mehrschritt-
Trellis-
Diagramm

multiplexen

$\bigcirc$ : ACS - Einheit, bestehend aus maximal $N_z$ ACS-Zellen

Fig. 5

$N_z = 3$ Spalten

$\underline{\lambda}_{LM}$

$\underline{\lambda}_{(L-1)M+1}$

$\underline{\lambda}_{(L-2)M+2}$

$\underline{\lambda}_{(L-3)M+3}$

parallele
Eingabe
von

M Sätzen
von $\lambda$

$\underline{\lambda}_{(L-4)M+4}$

$\underline{\lambda}_{(L-5)M+5}$

Hier: (M=9)
M−1=8
Reihen

$\underline{\lambda}_{(L-6)M+6}$

$\underline{\lambda}_{(L-7)M+7}$

$\underline{\lambda}_{(L-8)M+8}$

ACS, basierend auf dem
Mehrschritt-Trellis-
Diagramm

Zustandsmetriken-
Rückführung

Erläuterungen:   $\underline{\lambda}$   Zustandsmetriken (Eingang)

Zustandsmetriken (Ausgang)

Fig. 6

$$z.B.: \quad A = L \cdot \frac{F \cdot N_z}{(F-1)N_z + M}$$

$$B = L - A$$

Fig. 7

$N_z$  Spalten

$\underline{\lambda}_{LM}$

$\underline{\lambda}_{(L-1)M+1}$

$\underline{\lambda}_{(L-2)M+2}$

$\underline{\lambda}_{(L-F)M+F}$

F − 1
Reihen

$\underline{\lambda}_{(L-F-1)M+F+1}$

$\underline{\lambda}_{(L-M+1)M+M-1}$

M − F
Reihen

Ergänzung der
Pfade und Metriken

ACS basierend auf dem
Mehschritt-Trellis-Diagramm

Zustands-
Metriken-
Rückführung

Fig. 8

Fig. 9

Auswahl

Auswahl

unabhängig
voneinander
(parallel)
berechnete Pfade

unabhängig zu
dekodierende Blöcke
der Länge M (für M>B)

Fig. 10

eindeutig von Block zu Block
unabhängig dekodierte Blöcke
von M Übergängen
(des Original-Trellis-Diagramms)

unabhängig
(parallel)

berechnete Pfade

Fig. 11

k-te Hierarchiestufe
eines
Mehrschritt -Trellis-
Diagramm

1. Mehrschritt-Trellis-
Diagramm

Original-Trellis-
Diagramm

Fig. 12